# EUROPÄISCHE PATENTSCHRIFT

(11) **EP 1 846 959 B1**
(45) Veröffentlichungstag und Bekanntmachung des Hinweises auf die Patenterteilung: **02.05.2012**
(21) Anmeldenummer: 06701639.4
(22) Anmeldetag: 20.01.2006
(51) Int. Cl.: H01L 41/09, H01L 41/047

(54) **PIEZOELEKTRISCHES ELEMENT**
PIEZOELECTRIC ELEMENT
ELEMENT PIEZO-ELECTRIQUE

(30) Priorität: 11.02.2005 DE 202005002216 U
(43) Veröffentlichungstag der Anmeldung: 24.10.2007
(73) Patentinhaber: Johnson Matthey Catalysts (Germany) GmbH, 96257 Redwitz (DE)
(72) Erfinder: VAN DER LINDEN, Klaus, 96257 Redwitz (DE); KLUMP, Stefan, 96215 Lichtenfels (DE)
(74) Vertreter: FDST Patentanwälte
(86) Internationale Anmeldenummer: PCT/EP2006/000482
(87) Internationale Veröffentlichungsnummer: WO 2006/084554

(56) Entgegenhaltungen:
- EP-A- 1 199 758
- EP-A1- 0 455 342
- US-A1- 2003 020 375
- US-B1- 6 376 971

## Beschreibung

Die Erfindung betrifft ein piezoelektrisches Element mit einem Tragkörper und einer darauf aufgebrachten Piezokeramik. Die Erfindung nimmt dabei Bezug auf das Problem, für ein derartiges piezoelektrisches Element die Ausfallsicherheit sowie die Herstellkosten weiter zu verringern.

Ein piezoelektrisches Element der eingangs genannten Art dient vorrangig zur Ausnutzung des indirekten oder reziproken piezoelektrischen Effekts, d.h. der Umwandlung von elektrischer in mechanische Energie. Gleichwohl eignet sich ein derartiges piezoelektrisches Element aber auch dazu, mechanische in elektrische Energie umzuwandeln. Hierbei wird der direkte piezoelektrische Effekt ausgenutzt.

Für ein piezoelektrisches Element der genannten Art gibt es eine Vielzahl von technischen Anwendungen. Solche Anwendungen sind z.B. als Druckkopf für einen Tintenstrahldrucker, als Schallaufnehmer oder Schallerzeuger in einem Mikrofon oder einem Lautsprecher, als Sensor für die Beschleunigungs- oder Druckmessung, als Ultraschall-Wandler, als präzises Verstellelement im µm-Bereich oder als Biegewandler, beispielsweise als Stellelement in Braille-Zeilen eines Blinden-Lesegeräts; in einer Textilmaschine oder in einem schreibenden Messgerät.

Aus der EP 0 455 342 B1 oder der EP 0 468 796 A1 ist ein in Schichtstruktur aufgebautes piezoelektrisches Element bekannt. Zur Verbesserung der mechanischen Stabilität des Elements oder zur Erhöhung des Wirkungsgrades wird ein Piezoelektret, unter dem im folgenden ein piezoelektrisch aktives Material verstanden wird, welches den piezoelektrischen und/oder den elektrostriktiven Effekt zeigt, auf einen Tragkörper aufgebracht. Für die elektrische Kontaktierung und Ansteuerung ist der Piezoelektret mit Elektroden in Form einer flächigen Belegung aus einem leitfähigen Material versehen.

Gemäß der DE 34 34 726 C2 können auch mehrere Lagen von Piezoelektreten einschließlich der Elektroden übereinander gestapelt sein. Je nach der Anzahl der Piezoelektreten spricht man von einem mono-, bi-, tri- oder allgemein multimorphen piezoelektrischen Element.

Für die Elektroden ist beispielsweise aus der DE 40 25 436 A1 bekannt, diese in Form einer Metallisierung auf den Piezoelektreten aufzubringen. Eine derartige Metallisierung wird üblicherweise durch Sputtern aufgetragen. Als Metallisierungsschicht werden wegen ihrer technischen Eigenschaften Edelmetalle eingesetzt. Hierzu ist aus der WO 97/44834 A1 auch bekannt, die als Elektrode eingesetzte Metallisierungsschicht durch Verdampfen eines Metalls oder im Siebdruckverfahren aufzubringen. Eine Metallisierung in Form einer dünnen metallischen Oberflächenbeschichtung ist für die Erzeugung eines homogenen elektrischen Feldes im Piezoelektreten und damit für eine optimale Energieumsetzung notwendig. In der selben Schrift ist weiter offenbart, für ein piezoelektrisches Element mit einem Tragkörper aus einem isolierenden Material zur Vermeidung von durch Rissbildung in den Metallisierungselektroden auftretenden Ausfällen oder Fehlfunktionen zusätzlich zu einer Metallisierungselektrode eine leitfähige Belegung einzulegen, die Risse oder dergleichen elektrisch überbrückt.

Nachteiligerweise ist das Aufbringen einer Metallisierungselektrode durch Sputtern aufwändig und sehr kostenintensiv. Dies liegt zum einen an den benötigten Verfahrensschritten selbst, zum anderen aber auch an notwendigen Edelmetallen. Aufgabe der Erfindung ist es, ein piezoelektrisches Element der eingangs genannten Art anzugeben, welches gegenüber dem Stand der Technik bei gleicher Ausfallsicherheit weniger aufwändig und daher kostengünstiger hergestellt werden kann.

Diese Aufgabe wird für ein piezoelektrisches Element der eingangs genannten Art erfindungsgemäß dadurch gelöst, dass unmittelbar auf einer von einer Metallisierung freien Piezokeramik eine duktile leitfähige Schicht aus einem elektrisch leitenden Kunststoff als innere Elektrode angeordnet ist.

Zur Herstellung der Funktionsfähigkeit muss eine Piezokeramik zunächst in einem homogenen elektrischen Feld von einigen KV / mm polarisiert werden. Auf diese Weise wird in der Piezokeramik eine polare Achse erzeugt, die für das Auftreten des piezoelektrischen Effekts notwendig ist. Aufgrund der hohen elektrischen Leitfähigkeit und durch die flächige Belegung lässt sich durch Anlegen einer genügend hohen elektrischen Spannung an eine Stelle einer vorhandenen Metallisierung entlang der Piezokeramik ein weitgehend homogenes elektrisches Feld erzeugen, welches eine effektive Polarisation ermöglicht. Darüber hinaus ermöglicht das bei Anlegen einer Betriebsspannung an eine Metallisierung entstehende homogene elektrische Feld im Betrieb des piezoelektrischen Elements eine Ausnutzung des piezoelektrischen oder elektrostriktiven Effekts mit hohem Wirkungsgrad.

Die Fachwelt hat bislang Vorbehalte, für ein piezoelektrisches Element mit guten technischen Eigenschaften von einer auf dem Piezoelektreten aufgebrachten Metallisierungselektrode gänzlich abzusehen. Der in der WO 97/44834 A1 erkannte Nachteil von Rissen in der eher spröden inneren Metallisierungselektrode wird durch Einlegen einer zusätzlichen leitfähigen Belegung kompensiert.

Die Erfindung löst sich nun überraschenderweise von diesem Vorurteil der Fachwelt. Anstelle einer aufgetragenen inneren Metallisierung wird eine duktile, d.h. eine flexible und verformbare, leitfähige Schicht aus einem elektrisch leitenden Kunststoff aufgebracht. Diese Schicht kann in wenig aufwändiger Art und Weise beispielsweise aufgeklebt, aufgeschmolzen, aufgesprüht oder als Lack aufgetragen werden.

Die Erfindung geht dabei in einem ersten Schritt von der Überlegung aus, dass zum Erreichen einer effektiven Polarisation gar kein möglichst niedriger elektrischer Widerstand in der den Piezoelektreten umgebenden Elektrode nötig ist. Näherungsweise kann nämlich der Piezoelektret als idealer Kondensator aufgefasst werden, so dass ein erhöhter elektrischer Widerstand bei Anlegen einer hohen elektrischen Spannung zum Zwecke der Polarisation lediglich den Kondensatorladestrom im ersten Moment des Anlegens der Spannung reduziert. Für die Polarisation genügt ein homogenes elektrisches Feld genügend hoher Stärke als solches.

In einem zweiten Schritt erkennt die Erfindung, dass im Betrieb eines piezoelektrischen Elements der eingangs genannten Art eine Elektrode mit einem erhöhten elektrischen Widerstand nicht stört, sondern hilft, zu hohe Ladeströme zu vermeiden. Eine derartige Elektrode unterstützt einen vorgeschriebenen externen Ladevorwiderstand, da zu hohe Ladeströme wegen der Gefahr einer Depolarisation dem Piezoelektreten, insbesondere einer Piezokeramik, schaden.

Die Erfindung erkennt demnach, dass das Festhalten an einer leitfähigen Metallisierung mit hoher elektrischer Leitfähigkeit als innere Elektrode nicht notwendig ist. Diese Erkenntnis eröffnet die Wahl einer duktilen leitfähigen Schicht aus einem elektrisch leitenden Kunststoff, die nicht die Sprödigkeit einer aufgebrachten Metallisierung aufweist. Ein derartiges piezoelektrisches Element zeigt aufgrund der Duktilität keine Rissbildung in der Elektrode. Es weist demnach eine höhere Ausfallsicherheit auf als ein vergleichbares piezoelektrisches Element mit Metallisierungselektrode. Darüber hinaus entfallen die vergleichsweise hohen Kosten für das komplizierte Aufbringen einer Metallisierung sowie die Kosten für bislang verwendete Edelmetalle. Untersuchungen haben ergeben, dass ein piezoelektrisches Element mit einer duktilen leitfähigen Schicht als innere Elektrode keine technischen Nachteile gegenüber einem piezoelektrischen Element mit einer inneren Metallisierungselektrode zeigt. Auch die Homogenität einer durch Sputtern flächig aufgebrachten Metallisierung ist nicht erforderlich.

Vorteilhafterweise ist die duktile leitfähige Schicht als Elektrode beidseitig unmittelbar auf der Piezokeramik angeordnet. Ein derartiges Element ist unabhängig von einem späteren Einbau über seine beiden aufgebrachten Elektrodenseiten ansteuerbar. Auf eine Metallisierung der Piezokeramik wird gänzlich verzichtet.

Der Tragkörper selbst kann prinzipiell aus jedem beliebigen geeigneten Material sein. Insbesondere kann je nach Anforderung als Material ein Metall, ein Kunststoff oder ein Verbundmaterial verwendet werden. Für Biegewandler kann beispielsweise als Material für den Tragkörper ein Duroplast, insbesondere ein Epoxidharz, eingesetzt werden. In einer vorteilhaften Ausgestaltung ist der Tragkörper selbst aus einem piezoelektrisch aktiven Material. Auf diese Weise wird ein alternierender Schichtaufbau, in dem sich duktile Elektroden und Piezoelektreten abwechseln, ermöglicht. Ein derartiges Element ist äußerst vielseitig einsetzbar, beispielsweise als ein Stellelement, welches lange Stellwege oder hohe Stellkräfte ermöglichen soll.

Von Vorteil für eine Piezokeramik sind bestimmte Oxidkeramiken, z.B. Blei-Zirkonat-Titan (PZT), die über ihre Zusammensetzung eine Anpassung an unterschiedliche Anforderungen erlauben.

Zur Polarisation einer Piezokeramik hat es sich als vorteilhaft herausgestellt, die duktile Schicht großflächig zu kontaktieren, um gegebenenfalls vorhandene hochohmige Stellen auszuschalten.

Eine besonders gute Umsetzung von elektrischer Energie in mechanische Energie ist möglich, wenn der Tragkörper die Form eines flachen Plättchens hat und beidseitig mit der Piezokeramik versehen ist, wobei die duktile leitfähige Schicht als Elektrode beidseitig unmittelbar auf jeder Piezokeramik aufgebracht ist. Ein derartiges Element eignet sich insbesondere für die Verwendung als ein Biegewandler oder Aktor. Derartige Biegewandler werden in der Textilindustrie zur Ansteuerung von Web-, Wirk-oder Strickmaschinen, insbesondere für die Erzeugung von Mustern mit Hilfe der Jacquard-Technik, eingesetzt. Des weiteren wird ein solcher Aktor für Blinden-Lesegeräte zur Betätigung einzelner Tastenelemente, in Pneumatik-Ventilen oder Video-/Audio-Geräten eingesetzt.

In einer weiteren vorteilhaften Ausgestaltung ist der Tragkörper elektrisch isolierend. Ein piezoelektrisches Element mit einem isolierenden Tragkörper zeigt eine hohe Berührsicherheit. Die Ansteuerung durch Anlegen einer Spannung kann allein durch eine innere Elektrode erfolgen, während die äußere Elektrode oder Elektroden auf Nullpotential liegt bzw. liegen. Hierzu kann beispielsweise die spannungsführende innere Elektrode nach außen vollständig isoliert sein, indem der Tragkörper beispielsweise die innere Elektrode übergreift. Alternativ lässt sich eine Berührsicherheit durch Anwendung eines elektrisch isolierenden Lacks erreichen. Zweckmäßigerweise ist die Schicht elastisch. Auf diese Weise kann die Schicht den Bewegungen des piezoelektrischen Elements folgen, ohne selbst zu brechen oder Rißbildung zu zeigen. Die Gefahr eines Ausfalls wird damit verringert. Die Lebensdauer des piezoelektrischen Elements erhöht sich.

Für die Herstellung des piezoelektrischen Elements ist es vorteilhaft, wenn die Schicht als ein Lack aufgebracht ist. Der Lack kann in flüssiger oder pulverförmiger Form in einfacher Art und Weise durch Aufstreichen, Aufsprühen oder Tauchen aufgebracht werden, wobei sich dann durch Verdunsten oder Härten der Löse- oder Bindemittel die duktile Schicht auf der Oberfläche bildet.

Die Schicht besteht aus einem elektrisch leitenden Kunststoff. Als Kunststoff ist dabei besonders ein Carbon-Polymer oder ein mit Metallfasern verstärktes Epoxidharz von Vorteil. Unter einem Carbon-Polymer wird dabei ein insbesondere hitzehärtendes Harz mit Graphit als Pigment verstanden. Das Carbon-Polymer läßt sich vor der Aushärtung in Form einer Paste beispielsweise durch ein Siebdruckverfahren auftragen. Ein mit Metallfasern verstärktes Epoxidharz kann beispielsweise in Form eines Prepregs, d.h. ein noch nicht ausgehärteter Rohling, aufgelegt und anschließend unter Druck verpresst und durch eine Wärmebehandlung verklebt werden.

Ein Ausführungsbeispiel der Erfindung wird anhand einer Zeichnung näher erläutert. Dabei zeigt:

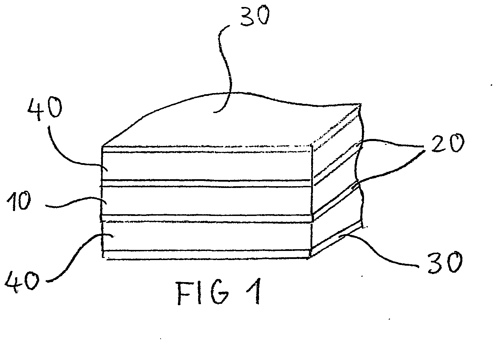

- Figur 1: in einem Querschnitt schematisch den Aufbau eines piezoelektrischen Elements.

Figur 1 zeigt in einem Querschnitt schematisch anhand eines Biegewandlers den Aufbau eines piezoelektrischen Elements. Als Tragkörper 10 ist ein flaches Plättchen aus einem elektrisch isolierenden, faserverstärkten Verbundkunststoff eingesetzt. Als innere Elektroden 20 ist auf beiden Seiten des Tragkörpers 10 jeweils eine Schicht aus einem leitfähigen duktilen Carbon-Polymer auf Basis eines Epoxidharzes eingesetzt. Die inneren Elektroden 20 sind beide direkt auf einer PZT-Keramik 40 angeordnet. Auf eine Metallisierungsschicht ist gänzlich verzichtet. Die inneren Elektroden 20 dienen zusammen mit äußeren Elektroden 30 zur Ansteuerung der jeweils dazwischen liegenden PZT-Keramik 40. Auch die äußeren Elektroden 30 sind jeweils als eine Schicht aus einem leitfähigen duktilen Carbon-Polymer auf Basis eines Epoxidharzes direkt auf der PZT-Keramik 40 angeordnet. Die äußeren und inneren Elektroden 30 bzw. 20 können auch zur Polarisation der PZT-Keramik 40 verwendet werden.

### Bezugszeichenliste

- 10: Tragkörper
- 20: innere Elektrode
- 30: äußere Elektrode
- 40: PZT-Keramik

## Patentansprüche

1. Piezoelektrisches Element mit einem Tragkörper (10), auf welchem eine Piezokeramik (40) aufgebracht ist, wobei eine duktile leitfähige Schicht aus einem elektrisch leitenden Kunststoff als innere Elektrode (20) unmittelbar auf der von einer Metallisierung freien Piezokeramik (40) angeordnet ist.

2. Piezoelektrisches Element nach Anspruch 1, wobei die duktile leitfähige Schicht als Elektrode (20, 30) beidseitig unmittelbar auf der Piezokeramik (40) angeordnet ist.

3. Piezoelektrisches Element nach Anspruch 1 oder 2, wobei der Tragkörper (10) aus einem piezoelektrisch aktiven Material ist.

4. Piezoelektrisches Element nach Anspruch 1 oder 2, wobei der Tragkörper (10) die Form eines flachen Plättchens hat und beidseitig mit der Piezokeramik (40) versehen ist, und dass die duktile leitfähige Schicht als Elektrode (20, 30) beidseitig unmittelbar auf jeder Piezokeramik (40) angeordnet ist.

5. Piezoelektrisches Element nach einem der Ansprüche 1 bis 4, wobei der Tragkörper (10) elektrisch isolierend ist.

6. Piezoelektrisches Element nach einem der Ansprüche 1 bis 5, wobei die Schicht elastisch ist.

7. Piezoelektrisches Element nach einem der Ansprüche 1 bis 6, wobei die Schicht als Lack aufgebracht ist.

8. Piezoelektrisches Element nach einem der Ansprüche 1 bis 7, wobei der elektrisch leitende Kunststoff ein Carbon-Polymer ist.

9. Piezoelektrisches Element nach einem der Ansprüche 1 bis 7, wobei der elektrisch leitende Kunststoff ein mit Metallfasern verstärktes Epoxidharz ist.

## Claims

1. Piezoelectric element with a supporting body (10), on which a piezo ceramic (40) is placed, wherein a ductile conductive layer of an electrically conducting plastic is arranged directly on the metallization-free piezo ceramic (40) as an inner electrode (20).

2. Piezoelectric element according to Claim 1, wherein the ductile conductive layer is arranged directly on the piezo ceramic (40) on both sides as an electrode (20, 30).

3. Piezoelectric element according to Claim 1 or 2, wherein the supporting body (10) is of a piezoelectrically active material.

4. Piezoelectric element according to Claim 1 or 2, wherein the supporting body (10) has the form of a small flat plate and is provided on both sides with the piezo ceramic (40), and wherein the ductile conductive layer is arranged directly on each piezo ceramic (40) on both sides as an electrode (20, 30).

5. Piezoelectric element according to one of Claims 1 to 4, wherein the supporting body (10) is electrically insulating.

6. Piezoelectric element according to one of Claims 1 to 5, wherein the layer is elastic.

7. Piezoelectric element according to one of Claims 1 to 6, wherein the layer is applied as a coating.

8. Piezoelectric element according to one of Claims 1 to 7, wherein the electrically conducting plastic is a carbon polymer.

9. Piezoelectric element according to one of Claims 1 to 7, wherein the electrically conducting plastic is an epoxy resin reinforced with metal fibres.

## Revendications

1. Elément piézoélectrique présentant un corps porteur (10) sur lequel une piézocéramique (40) est appliquée,
dans lequel une couche conductrice ductile constituée d'une matière synthétique électriquement conductrice est disposée en tant qu'électrode intérieure (20) directement sur la piézocéramique (40) exempte de métallisation.

2. Elément piézoélectrique selon la revendication 1, dans lequel une couche conductrice ductile servant d'électrode (20, 30) est disposée directement sur chacun des deux côtés de la piézocéramique (40).

3. Elément piézoélectrique selon la revendication 1 ou 2, dans lequel le corps porteur (10) est constitué d'un matériau piézoélectriquement actif.

4. Elément piézoélectrique selon la revendication 1 ou 2, dans lequel le corps porteur (10) a la forme d'une plaquette aplatie et est doté sur ses deux côtés de la piézocéramique (40), et dans lequel les couches conductrices ductiles servant d'électrodes (20, 30) sont disposées directement sur chacun des deux côtés de chaque piézocéramique (40).

5. Elément piézoélectrique selon l'une des revendications 1 à 4, dans lequel le corps porteur (10) est électriquement isolant.

6. Elément piézoélectrique selon l'une des revendications 1 à 5, dans lequel la couche est élastique.

7. Elément piézoélectrique selon l'une des revendications 1 à 6, dans lequel la couche est appliquée sous la forme d'un vernis.

8. Elément piézoélectrique selon l'une des revendications 1 à 7, dans lequel la matière synthétique électriquement conductrice est un polymère de carbone.

9. Elément piézoélectrique selon l'une des revendications 1 à 7, dans lequel la couche électriquement conductrice est une résine époxy renforcée de fibres métalliques.
